Europäisches Patentamt

European Patent Office

Office européen des brevets

(19)

(11) Publication number: **0 387 010**
**A2**

# EUROPEAN PATENT APPLICATION

(21) Application number: 90302391.9

(51) Int. Cl.⁵: **H01L 29/73, H01L 29/62**

(22) Date of filing: **06.03.90**

(30) Priority: **08.03.89 JP 56849/89**
**08.03.89 JP 56846/89**

(43) Date of publication of application:
**12.09.90 Bulletin 90/37**

(84) Designated Contracting States:
**DE FR GB NL**

(71) Applicant: **MATSUSHITA ELECTRIC**
**INDUSTRIAL CO., LTD.**
**1006, Kadoma**
**Kadoma-shi Osaka 571(JP)**

(72) Inventor: **Inada, Masanori**
**5-8-11 Midorigaoka, Heguri-cho**
**Ikoma-gun, Nara-ken(JP)**
Inventor: **Ryoji, Akira**
**7-30 Suehiro-cho**
**Neyagawa-shi, Osaka-fu(JP)**

(74) Representative: **Crawford, Andrew Birkby et al**
**A.A. THORNTON & CO. Northumberland**
**House 303-306 High Holborn**
**London WC1V 7LE(GB)**

(54) **Hetero-junction bipolar transistor.**

(57) An object of the present invention is to suppress the surface recombination over the whole area of the external base of a hetero-junction bipolar transistor (HBT), to keep the current gain large, and to reduce the base contact resistance. The HBT of the invention has, as a surface protective film layer, a p-type semiconductor layer which has the higher portential of the energy conduction band than the base layer on an external base outside the junction between the mesa of the n-type emitter layer and the p-type base layer, and a base electrode thereon. Preferably, it has as a base contact layer a p-type semiconductor layer which shows reduced contact resistance with the base electrode on the surface protective layer comprising a p-type semiconductor layer. More preferabiy, it has a structure wherein a base electrode is formed on the base contact layer in contact with the projection part of the emitter electrode to the base contact layers A method of producing this HBT comprises at least the steps of forming an emitter mask on the portion to be an emitter on a multi-layer structure material having an n-type semiconductor layer for forming a collector, a p-type semiconductor layer or forming a base, and an n-type semiconductor layer for forming an emitter in this order from the substrate, and etching by using the emitter mask to form an emitter mesa and to expose a base layer; epitaxially forming as a surface protective film layer a p-type semiconductor layer which show the higher potential of the energy conduction band than the base layer on the external base outside the junction part between the emitter mesa and the base layer by using the emitter mask; and epitaxially forming a base electrode on the p-type surface protective film layer.

## HETERO-JUNCTION BIPOLAR TRANSISTOR

The present invention relates to a hetero-junction bipolar transistor (HBT) which is promising as a super high speed, super high frequency device.

In HBT, a semiconductor material having the larger energy band gap than the base is used as an emitter. Accordingly, a reverse injection from the base to the emitter is suppressed, and the injection efficiency of the carrier from the emitter to the base is enlarged. For this reason, different from an ordinary homo-junction bipolar transistor, the emitter can be formed into low dope and the base into high dope state. As this permits to reduce the base resistance, it is advantageous to make the maximum oscillation frequency Fm large. Further, as it is possible to make the base thinner and greatly shorten the base running time of minority carriers injected from the emitter and reduce the junction capacitance between the emitter and the base, HBT is essentially advantageous for enlarging the current gain cut-off frequency Ft. For these reasons, HBT is vigorously studied and developed as a super high frequency device.

However, in order to effectively utilize these essential merits, the important technical subjects are to reduce the parasitic resistance and capacitance dependent on the size of each part of device and the contact resistances of the emitter, the base and the collector. To solve these subjects, there have been developed various kinds of self-alignment techniques which permits formation of emitter electrode and outgoing wiring from the emitter even by reducing the emitter size, which permits to form a base electrode adjacent to the emitter and to reduce the components of the base resistance dependent on the distance between the base electrode and the emitter, or which permits to make the collector size small (e.g.. reference literature: Japanese Patent Application No.61-193294). Further, the technical developments for reducing the contact resistances of emitter, base, and collector are vigorously carried out.

However, due to the minimization of the device size, problematic points also arise. For example, when a device is minimized, there arises a problem such that the recombination on the base layer surface causes to enlarge the base current and remarkably lower the current gain

Against the above problem, there have been studied the methods of solving the problem. For example, it is reported that, when the surface of the exposed base layer is coated with $Na_2S \cdot 9H_2O$ (reference literature: C. J. Sandroff et al.: Appl. Phys. Lett., Vol.51, pp.33-35, 1987; Nottenburg et al.: Appl. Phys. Lett., Vol.52, pp.218-220, 1989), the surface recombination is suppressed to enlarge $\beta$ .

However, the said material is not practical as it readily reacts with moisture in air. Besides, there is reported a structure wherein a wide band gap emitter is thinly formed, a mesa comprisng an emitter cap layer formed for reducing an emitter contact resistance is formed on part of a mesa of the wide band gap emitter layer, and a base electrode is formed on the base layer outside the mesa of wide band gap emitter layer (reference literature: W. E. Lee et al., IEEE Electron Device Lett., Vol.EDL-10, pp.202-202, 1989). According to this structure, as the base surface between the mesa of the emitter cap layer and the base electrode is covered with the depleted wide band gap emitter layer which is in epitaxial relation to each other, the defects dependent on surface dungling bonds are decreased, and as the potential of the energy conduction band of the depleted emitter layer is higher than that of the base layer, the surface recombination is remarkably reduced, thereby making it possible to prevent the lowering of $\beta$ . However, as the diffusion distance of electrons injected from the emitter through the base layer is large, when the distance between the base electrode and the emitter is set to no more than 1 $\mu$m, the electrons reach up to the base electrode portion, where the recombination is enlarged to cause $\beta$ rapidly low, so that with the value of no more than 0.5 $\mu$m the effect is considerably minimized. Accordingly, in the case of the self-alignment type HBT having a distance between the base electrode and the emitter of about 0.25 $\mu$m aiming at reducing the base resistance, there has been a problematic point in making the effect thereof extremely small. In other words, in this structure, for formation of a base electrode having small contact resistance, elimination of depleted emitter layer is indispensable, so that it is impossible to suppress the electrons which reach the base electrode. Accordingly, this structure is not much effective for the self-alignment type HBT for reducing the base resistance.

An object of the present invention is to keep the current gain large by suppressing the surface recombination over the whole area of the external base of a hetero-junction bipolar transistor (HBT) and to render the base resistance small.

In order to attain the above object, the HBT of the present invention has, as a surface protective film layer, an epitaxially formed p-type semiconductor layer which has the higher portential of the energy conduction band than that of the base layer on an external base layer outside the junction between the mesa of the n-type emitter layer and the p-type base layer, and has a base electrode thereon. Preferably, the HBT has, on the p-type surface protective layer a p-type semiconouctor layer which shows a smaller contact resistance with the base electrode. More preferably, a base electrode is formed adjacent to the emitter.

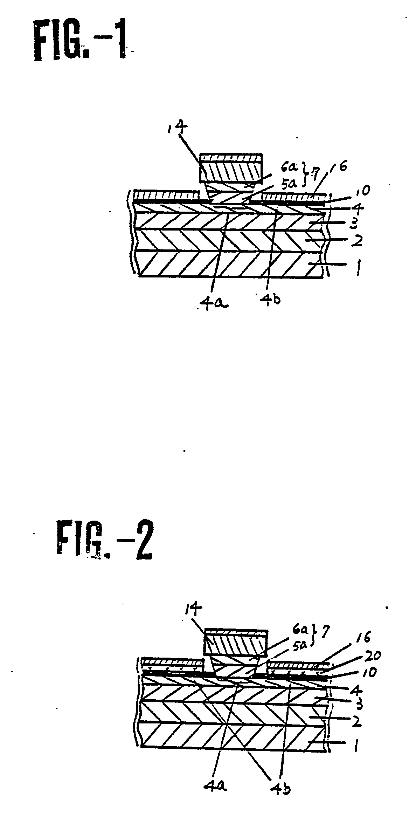

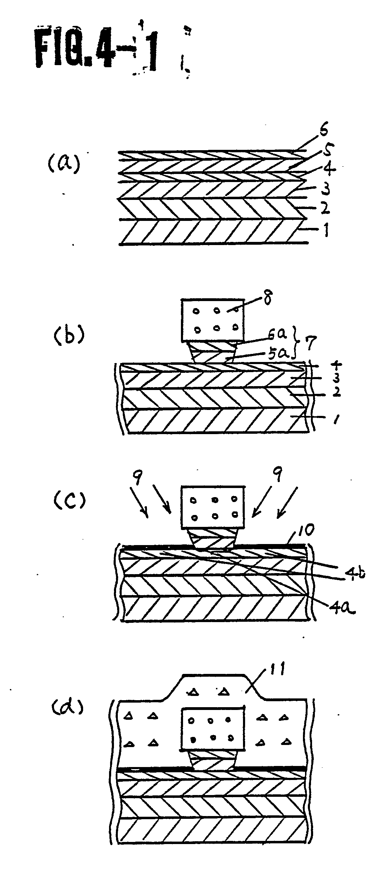

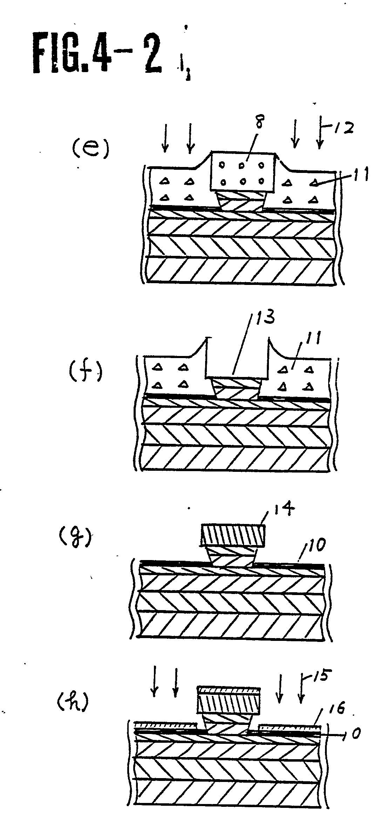

Fig. 1, Fig 2, and Fig. 3 are the sectional views showing the embodiment of the structure of HBT according to the present invention. Fig. 4, Fig. 5, and Fig. 6 are the sectional views showing the embodiments of the method of producing the HBT according to the present invention. In Figs. 1 to 6, each number denotes the following:

1 ... semi-insulating GaAs substrate (S, I, GaAs), 2 ... n-type highly doped GaAs ($n^+$-GaAs), 3 ... n-type doped GaAs (n-GaAs), 4 ... p-type highly doped GaAs ($p^+$-GaAs), 4a ... intrinsic base part comprising 4, 4b ... external base part comprising the layer 4, 5 ... n-type doped $Al_0 \cdot 3Ga_0 \cdot 7As$ (n-$Al_0 \cdot 3 Ga_0 \cdot 7$ As), 5a ... layer of 5 constituting an emitter mesa, 6 ... n-type highly doped GaAs ($n^+$-GaAs), 6a ... layer of 6 constituting an emitter mesa, 7 ... emitter mesa constituted by 5a and 6a, 8 ... dummy emitter comprising $SiO_2$, 9 ... oblique direction molecular beam epitaxy, 10 ... p-type highly doped $Al_0 \cdot 4 Ga_0 \cdot 6As$ ($p^+$-$Al_0 \cdot 4Ga_0 \cdot 6As$), 11 ... photoresist, 12 ... dry etching, 13 ... opening part after removing $SiO_2$ dummy emitter, 14 ... emitter electrode, 15 ... metal vapor deposition, 16 ... base electrode metal, 17 ... upper direction molecular beam epitaxy, 18 ... dry etching, 20 ... p-type highly doped GaAs ($p^+$-GaAs), 30 ... p-type highly doped $Al_0 \cdot 4Ga_0 \cdot 6As$ ($p^+$-$Al_0 \cdot 4Ga_0 \cdot 6As$), 30a ... layer 30 lying between the emitter mesa and the base electrode.

The first embodiment of the HBT structure of the present invention is shown in Fig. 1. In Fig. 1 there is shown a relation between the emitter and the base which is an essential condition of the present invention. This HBT structure has a semi-insulating GaAs (S.I.- GaAs) 1, an n-type highly doped GaAs ($n^+$-GaAs) layer 2 for forming a collector contact layer, a collector layer 3 comprising an n-type doped GaAs (n-GaAs), a base layer 4 comprising a p-type highly doped GaAs ($p^+$-GaAs), an emitter mesa 7 comprising a wide band gap $Al_0 \cdot 3Ga_0 \cdot 7As$(n-$Al_0 \cdot 3Ga_0 \cdot 7$ As) emitter layer 5a which is n-type doped thereon and $n^+$-GaAs 6a, an emitter electrode 14 covering the emitter mesa 7 in an umbrella shape, a p-type highly doped $Al_0 \cdot 4Ga_0 \cdot 6$ As ($p^+$-$Al_0 \cdot 4Ga_0 \cdot 6As$) layer 10 as a surface protective film having the higher potential of the energy conduction band than that of the base on the external base 4b outside the emitter mesa 7, and a base electrode 16 on the outside of the projection part of the emitter electrode 14 onto the $p^+$-$A_{10} \cdot 4Ga_0 \cdot 6As$ layer 10.

In this HBT structure, a part of the electrons injected from the emitter to the intrinsic base part 4a joined to the emitter mesa 7 diffuses in the direction of the external base 4b, but, as the potential of the energy conduction band of the $p^+$-$Al_0 \cdot 4Ga_0 \cdot 6As$ layer 10 which is epitaxially formed on the external base 4b is higher than that of the base layer 4, these diffused electrons are reflected by this barrier and do not appear to the surface. Accordingly, this HBT shows extremely small surface recombination which is in general a problematic point in the AlGaAs/GaAs type HBT. Also, because the layer 10 is of a highly doped p-type, a base electrode can be formed thereon. For this reason, even in case of forming a base electrode 16 adacent to the emitter mesa 7 by self-alignment process so as to reduce the base resistance, not only the surface recombination between the emitter mesa 7 and the base electrode 16 is suppressed but also the leak of electrons to the base electrode 16 is suppressed. Accordingly, the HBT of this structure is extremely effective for preparing an HBT having small base resistance and large current gain.

According to this embodiment, there are used n-$Al_0 \cdot 3Ga_0 \cdot 7As$ as an emitter layer 5 and $p^+$-GaAs as a base layer 4. Alternatively, as the materials to satisfy the essential conditions of HBT there may be used n-$Al_0 \cdot 3Ga_0 \cdot 7As$ as an emitter and $p^+$-$Al_Y Ga_{1-Y}As$ (Y being fixed or varied; Y < X) having the smaller band gap than the former as a base. As a surface protective layer 10, p-$Al_0 \cdot 4Ga_0 \cdot 6As$ is used, which is in order to make the potential of the energy conduction band higher than $p^+$- GaAs. As a material which satisfies these conditions and yet can be epitaxially formed, there may be used $p^+$-$Al_Z Ga_{1-Z}As$ (Z > Y), if the intrinsic base is $p^+$-$Al_Y Ga_{1-Y}As$. As other material, for example, Ga(Sb, As) type material may be used.

In the embodiment HBT comprising AlGaAs/GaAs material is described. However, the HBT comprising other material may be similarly formed into the HBT structure of the present invention.

In the embodiment, the base electrode 16 exists adjacent to the emitter mesa in contact with the projection part of the emitter electrode 14 to the $p^+$-$Al_0 \cdot 4Ga_0 \cdot 6As$ layer 10. This state is formed by the production process of the present structure. This is because of the reduction of the component of the base resistance dependent on the distance between the emitter mesa and the base electrode so as to increase Fm. However, in order to increase Ft, the base electrode is not necessarily required to be formed in adjacent relation.

. This structure is formed in the following manner. Fig. 4 shows the process for production thereof. On S.I.-GaAs substrate, there are formed $n^+$-GaAs layer 2, n-GaAs layer 3, $p^+$-GaAs layer 4, n-$Al_0 \cdot 3Ga_0 \cdot 2As$ layer 5, and $n^+$-GaAs layer 6 in this order to prepare a multi-layer structure material by using molecular beam epitaxy (MBE) [Fig. 4(a)]; SiO$_2$ is formed over the whole surface; SiO$_2$ mask (dummy emitter) 8 is formed on a portion to be an emitter; and an emitter mesa 7 comprising n-Al$_0$•3Ga$_0$•7As 5a and n$^+$-GaAs 6a is formed by wet-etching using the dummy emitter 8 to expose a base layer 4 [Fig. 4(b)]. Next, from an oblique direction, a p$^+$-Al$_0$•4Ga$_0$•6As 10 is formed on the external base 4b by MBE [Fig. 4(c)]. The surface is rendered flat by spin coating with a photoresist 11 [Fig. 4(d)]. From the upper part, the resist is etched by dry etching to expose the head of the dummy emitter 8 [Fig. 4(e)]. Then, SiO$_2$ dummy emitter 8 is eliminated by HF to form an opening 13 of the resist to which the top surface of the emitter mesa 7 is exposed [Fig. 4(f)]. From the upper part AuGe/Ni/Au is vapor deposited as an emitter electrode, and lifted off to form an emitter electrode 14 [Fig. 4(g)]. Then, using the emitter electrode 14 as a mask, a base electrode 16 comprising Cr/AuZn/Au is formed by vapor deposition process [Fig. 4(h)].

When this method is employed, even when the emitter is small, an emitter electrode can be readily formed on an emitter mesa. On an external base layer, a protective layer which is capable of suppressing a surface recombination is epitaxially formed, and on it a base electrode can be formed adjacent to the emitter mesa by a self-alignment method.

In the embodiment, SiO$_2$ is used as a dummy emitter, but SiN$_x$ may be used.

In the embodiment, using the emitter electrode 14 as a mask, the base electrode 16 is formed by self-alignment against the emitter mesa 7. However, it may be practised that, using the dummy emitter 8 as a mask, the base electrode 16 is formed by self-alignment, followed by forming an emitter by inverting a dummy emitter 8 into an emitter.

In the embodiment, MBE process is employed for forming the p$^+$-Al$_0$•4Ga$_0$•6As layer, but any other epitaxy process such as metal-organic chemical vapor deposition (MO-CVD) may be used.

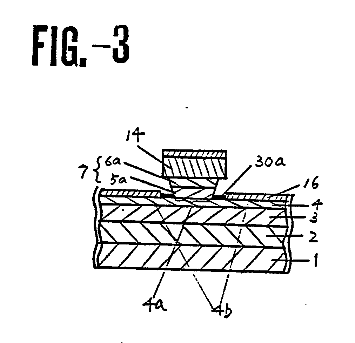

Fig 2 is a second embodiment of the structure of HBT of the present invention. The point of difference of this embodiment from the first embodiment is that a high dope p$^+$-GaAs is formed as a material for reducing the contact resistance with the base electrode 16 between the epitaxially formed p$^+$-Al$_0$•4Ga$_0$•6As layer 10 and the base electrode 16.

Even by the structure of Fig. 1, by the formation of a base electrode adjacent to the emitter mesa by self-alignment process and the formation of a surface protective layer having majority carriers of the same type as the base on an external base, reduction of base resistance and prevention of lowering of the current gain by surface recombination can be obtained. In this case, however, it may occur that the contact resistance between the surface protective layer and the base electrode becomes larger than the case where there is no surface protective layer. The second embodiment shows a structure of HBT which can not only suppress an increase of the base contact resistance in the case where the surface protective layer of the external base induces an increase in the base contact resistance but also can realize further reduction of the base contact resistance even when such increase is not induced. in the structure of Fig. 2, in p$^+$-GaAs, the base contact resistance can be rendered smaller than in p$^+$-Al$_0$•4Ga$_0$•6As, so that it has a characteristic of being capable of reducing the base resistance further than in the case of Fig. 1. In this case, as p$^+$-GaAs and p$^+$-Al$_z$Ga$_{1-z}$As are both highly doped, there is not formed a barrier to such a degree as to provide a cause for interrupting the hole running. As the concentration of the carrier of the base layer 4 cannot be so high so as to prevent undesirable effect on diffusion of dopant to the upper and lower layers existing in contact therewith and on epitaxy formation of the upper layer of the base layer, reduction of the base contact resistance is limited. In this structure, however, as it is possible to render the carrier concentration of the p$^+$-GaAs layer 20 for base contact formation extremely large, the base contact resistance can be rendered sufficiently small.

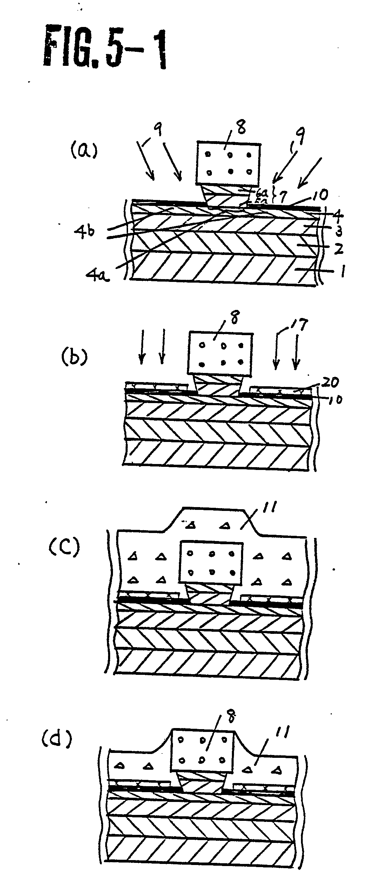

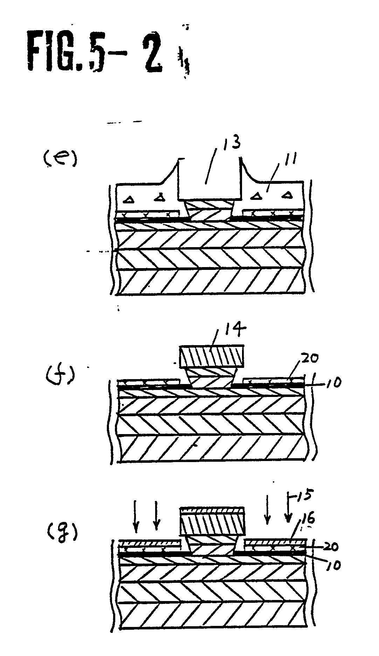

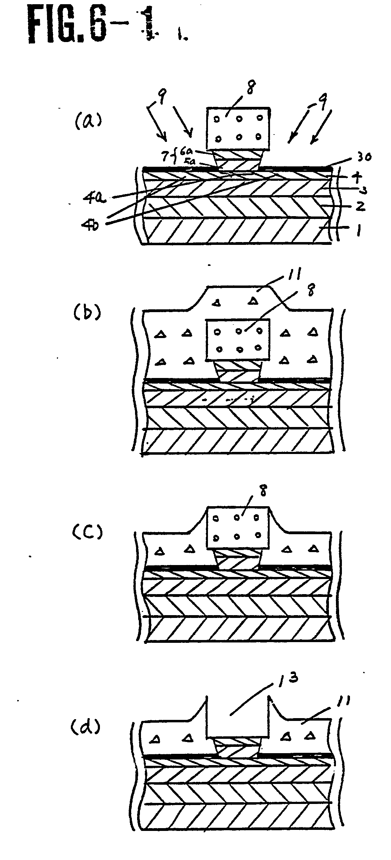

This structure can be formed in the following manner. Fig. 5 shows the process for production thereof. in the same manner as in Fig. 4(c), a surface protective film layer 10 is formed [Fig. 5(a)], and, using SiO$_2$ dummy emitter 8 as a mask, a base contact layer 20 is formed by MBE 17 from the upper part [Fig. 5(b)], and then, using the processes of from Fig. 4(d) to Fig. 4(g), the dummy emitter 8 is inverted to the emitter electrode 14 [Fig. 5 from (c) to (f)]. Next, in the same manner as in Fig. 4(h), a base electrode 16 is formed by self-alignment adjacent to the emitter mesa 7 [Fig. 5(g)].

The third embodiment of the present invention is shown in Fig. 3. The points of the difference of this embodiment from the first and second embodiments are that the surface protective film layer 30a of the p$^+$-GaAs external base 4b is positioned between the base electrode 16 which exists in contact with the projection part of the emitter electrode 14 to the external base 4b and the emitter mesa 7, the surface protective film layer 30a is epitaxially formed on the external base 4b, and it is formed of a material in which the potential of its energy conduction band is higher than that of the base. In this structure, as the base electrode 16 is formed by self-alignment adjacent to the emitter mesa 7, the base resistance is reduced, and as the surface protective film of the external base surface between the base electrode 16 and the emitter mesa 7 has the higher energy conduction band potential than the base, the surface recombination of this portion is suppressed, so that the lowering of current gain by surface recombination can be prevented. However, as there is no surface protective film layer on the lower part of the base electrode 16 which is formed adjacent to the emitter mesa 7, this structure shows the smaller effect of reduction of the current gain than the embodiments 1 and 2.

In the embodiments $p^+$-$Al_0 \cdot 4Ga_0 \cdot 6As$ is used as a surface protective film 30a, but it may be an insulating material if the potential of the energy conduction band is higher than that of the base.

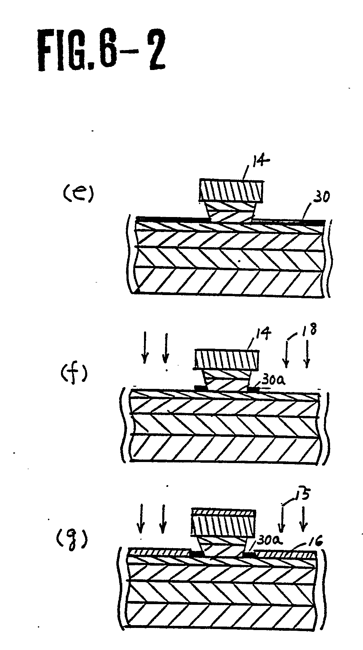

This structure can be formed in a manner as shown below. Fig. 6 shows a process for production of this structure. After the process of Fig. 4(b), by an oblique direction MBE 9, $p^+$-$Al_0 \cdot 4Ga_0 \cdot 6As$ 30 is epitaxially formed on the external base 4b [Fig. 6(a)], and then, using the processes similar to Fig. 4(d) to (g) [Fig. 6 (b) to (e)], the dummy emitter 8 is inverted to the emitter electode 14 [Fig. 6(e)]. Next, using the emitter electrode 14 as a mask, an anisotropic dry etching 18 is applied from the upper part to etch the $p^+$-$Al_zGa_{1-z}A$ layer 30 to form a surface protectrive film layer 30a only on the lower part of the emitter electrode 14 [Fig. 6(f)]. Next, using the emitter electrode 14 as a mask, a base electrode 16 is formed by self-alignment process by metal vapor deposition 15 from the upper part [Fig. 6(g)].

## Claims

1. A heterojunction bipolar transistor comprising:
a base layer comprising a p-type semiconductor;
a mesa of an emitter layer comprising an n-type semiconductor having the larger energy band gap than said base layer formed on said base layer;
an epitaxially formed surface protective film layer of p-type semi-conductor which shows the higher potential of energy conduction band than said base on the external base layer outside the junction part between said emitter mesa and said base layer; and
a base electrode formed on said surface protective film.

2. A heterojunction bipolar transistor according to Claim 1, wherein the n-type emitter material is $Al_xGa_{1-x}As$, the p-type base material is $Al_yGa_{1-y}As$ (Y <X), and the p-type surface protective film material is $Al_zGa_{1-z}As$ (Z > Y).

3. A heterojunction bipolar transistor according to Claim 1, which further comprises:
an emitter electrode covering the upper surface of the emitter mesa in an umbrella shape; and
a base electrode which is in contact with the projection part of said emitter electrode to the p-type surface protective film and is formd on said p-type surface protective film.

4. A heterojunction bipolar transistor comprising:
a base layer comprising a p-type semiconductor;
a mesa of an emitter layer comprising an n-type semiconductor having the larger energy band gap than said base layer formed on said base layer;
an epitaxially formed surface protective film of p-type semiconductor which shows the higher potential of energy conduction band than said base on the external base layer outside the junction part between said emitter mesa and said base layer;
a base contact layer comprising a p-tpe semiconductor which shows the lower contact resistance with the base electrode and which is epitaxially formed on said surface protective film; and
a base electrode on said base contact layer.

5. A heterojunction bipolar transistor according to Claim 4, wherein the n-type emitter is $Al_xGa_{1-x}As$, the p-type base is $Al_yGa_{1-y}As$ (Y <X), the p-type surface protective film layer is $Al_zGa_{1-z}As$ (Z > Y), and the p-type base contact layer is GaAs.

6. A heterojunction bipolar transistor according to Claim 4, which further comprises:
an emitter electrode covering the upper surface of the emitter mesa in an umbrella shape; and
a base electrode formed on the base contact layer comprising a p-type semiconductor which shows the smaller contact resistance with the base electrode in contact with the projection part of said emitter electrode to said p-type surface protective film.

7. A heterojunction bipolar transistor according to Claim 6, wherein the n-type emitter is $Al_xGa_{1-x}As$, the p-type base is $Al_yGa_{1-y}As$ (Y <X), the p-type surface protective film is $Al_zGa_{1-z}As$ (Z > Y), and the base contact layer is p-type GaAs.

8. A heterojunction bipolar transistor comprising:
a base layer comprising a p-type semiconductor;
a mesa of an emitter layer comprising an n-type semiconductor having the larger energy band gap than said base layer formed on said base layer;
an emitter electrode covering said emitter mesa in an umbrella shape; and
a base electrode formed on the base layer in contact with the projection part of said emitter electrode to the base layer; and
a surface protective film comprising a semiconductor material which shows the higher potential of energy conduction band than said base on the surface of the base layer lying between the junction part between said emitter mesa and said base layer and said base electrode.

9. a heterojunction bipolar transistor according to Claim 8, wherein the n-type emitter is $Al_XGa_{1-X}As$, the p-type base is $Al_YGa_{1-Y}As$ (Y< X), and the surface protective film is $Al_ZGa_{1-Z}As$ (Z > Y).

10. A method of producing a heterojunction bipolar transistor, comprising the steps of:
forming an emitter mask on the portion to be an emitter of a multi-layer structure material in which an n-type semiconductor layer for forming a collector layer, a p-type semiconductor layer for forming a base layer, and an n-type wide energy band gap semiconductor layer for forming an emitter layer are epitaxially formed in this order on a substrate material, carrying out etching by the use of said mask to form an emitter mesa and to expose said base layer;
epitaxially forming as a surface protective film layer a p-type semiconductor layer having the higher potential of the energy conduction band than the base layer on the external base layer outside the junction part between the emitter mesa and the base layer; and
forming a base electrode on said surface protective film layer.

11. A method according to Claim 10, wherein n-type $Al_XGa_{1-X}As$ is used as an emitter layer, p-type $Al_YGa_{1-Y}As$ (Y <X) as a base layer, and p-type $Al_ZGa_{1-Z}As$ (Z > Y) as a surface protective film layer.

12. A method according to Claim 10, comprising the steps of:
epitaxially forming a surface protective film layer comprising a p-type semiconductor;
followed by coating the surface with photoresist to flatten, and then exposing the surface of the top part of said emitter mask by dry etching, selectively removing said emitter mask to form an opening of said photoresist with exposure of the surface of the top part of the emitter mesa, and forming an emitter electrode on said part; and
vapor depositing base electrode metals by using said emitter electrode as a mask and forming said base electrode on said surface protective film in contact with the projection part of said emitter electrode to said surface protective film.

13. A method according to Claim 10, comprising the steps of:
epitaxially forming a surface protective film layer comprising a p-type semiconductor;
followed by vapor depositing base electrode metals by using said emitter mask as a mask on said surface protective film in contact with the projection part of said emitter mask to the surface protective film; and
coating the surface with photoresist to flatten, exposing the surface of the top part of said emitter mask by dry etching removing said emitter mask to form an opening of said photoresist with exposure of the surface of the top part of the emitter mesa, and forming an emitter electrode on said part.

14. A method of producing a heterojunction bipolar transistor, comprising the steps of:
forming an emitter mask on the portion to be an emitter of a multi-layer structure material in which an n-type semiconductor layer for forming a collector layer, a p-type semiconductor layer for forming a base layer, and an n-type wide energy band gap semiconductor layer for forming an emitter layer are epitaxially formed in this order on a substrate material, carrying out etching by the use of said emitter mask to form an emitter mesa and exposing said base layer;
epitaxially forming as a surface protective film layer a p-type semiconductor layer having the higher potential of the energy conduction band than the base layer on the external base layer outside the junction part between the emitter mesa and the base layer;
epitaxially forming as a base contact layer a p-type semiconductor layer which shows the smaller contact resistance with the base electrode on said surface protective film layer; and
forming a base electrode on said base contact layer.

15. A method according to Claim 14, wherein n-type $Al_XGa_{1-X}As$ is used as an emitter layer, p-type $Al_YGa_{1-Y}As$ (Y <X) as a base layer, p-type $Al_ZGa_{1-Z}As$ (Z > Y) as a surface protective film layer, and p-type GaAs as a base contact layer.

16. A method according to Claim 14, comprising the steps of:
epitaxially forming as a base contact layer a p-type semiconductor layer which shows the smaller contact resistance with the base electrode;
followed by coating the surface with photoresist to flatten, and then exposing the surface of the top part of said emitter mask by dry etching, removing said emitter mask to form an opening of said photoresist with exposure of the surface of the top part of the emitter mesa, and forming an emitter electrode on said part by metal vapor deposition; and
vapor depositing base electrode metals by using said emitter electrode as a mask and forming the base electrode on said base contact layer in contact with the projection part of said emitter electrode to said base contact layer.

17. A method of producing a heterojunction bipolar transistor, comprising the steps of:
forming an emitter mask on the portion to be an emitter of a multi-layer structure material in which an n-type semiconductor layer for forming a collector layer, a p-type semiconductor layer for forming a base layer, and an n-type wide energy band gap semiconductor layer for forming an emitter layer are epitaxially formed in this order on a substrate material, carrying out etching by the use of said emitter mask to form an emitter mesa and exposing said base layer;

forming as a surface protective film layer a semiconductor layer having the higher potential of the energy conduction band than the base layer on the base layer outside the junction part between the emitter mesa and the base layer;

coating the surface with photoresist to flatten, exposing the surface of the top part of the emitter mask by dry etching, removing said emitter mask to form an opening part of said photoresist, and forming an emitter electrode on said part;

removing said surface protective film layer other than the projection part of said emitter electrode to said surface protective film by dry etching by using said emitter electrode as a mask; and

forming a base electrode on the base layer in contact with the projection part of said emitter electrode to the base layer by vapor depositing base electrode metals by using said emitter electrode as a mask.

18. A method according to Claim 17, wherein $Al_xGa_{1-x}As$ is used as an n-type emitter, $Al_YGa_{1-Y}As$ ($Y < X$) as a p-type base, and $Al_ZGa_{1-Z}As$ ($Z > Y$) as a surface protective film.

# FIG.-1

# FIG.-2

# FIG.-3

# FIG.4-1

(a)

(b)

(c)

(d)

# FIG.4-2

(e)

(f)

(g)

(h)

# FIG. 5-1

# FIG.5- 2

(e)

(f)

(g)

# FIG.6-1

(a)

(b)

(c)

(d)

# FIG.6-2

(e)

(f)

(g)